Europäisches Patentamt

(19) European Patent Office

Office européen des brevets

(11) Publication number: **0 272 046**
**A2**

# (12) EUROPEAN PATENT APPLICATION

(21) Application number: 87310837.7

(22) Date of filing: 09.12.87

(51) Int. Cl.⁴: **H01L 23/48** , H01L 23/52 , H01L 21/48

The title of the invention has been amended (Guidelines for Examination in the EPO, A-III, 7.3).

(30) Priority: 18.12.86 GB 8630314

(43) Date of publication of application:
22.06.88 Bulletin 88/25

(84) Designated Contracting States:
AT BE CH DE ES FR GB GR IT LI LU NL SE

(71) Applicant: **MARCONI ELECTRONIC DEVICES LIMITED**
**The Grove Warren Lane**
**Stanmore Middlesex HA7 4LY(GB)**

(72) Inventor: **Anderson, Russell David**
**41 Ely Close Toothill**
**Swindon Wiltshire SN5 8DB(GB)**

(74) Representative: Hoste, Colin Francis
**The General Electric Company p.l.c. Central Patent Department (Wembley Office) Hirst Research Centre East Lane Wembley Middlesex, HA9 7PP(GB)**

(54) **Circuit arrangement including a composite ceramic substrate.**

(57) A circuit arrangement consists of a number of ceramic layers fired together to form a unitary multilayer structure, some of the layers carry conductive circuit patterns with conductive via connections between different layers of circuit pattern. A recess is formed through a number of the ceramic layers, and a semiconductor device is mounted in the recess within the thickness of the unitary structure. The recess is provided with a lid to hermetically seal the enclosure.

EP 0 272 046 A2

FIG. I.

### Circuit Arrangement

This invention relates to a circuit arrangement, and is specifically concerned with a multilayer circuit arrangement in which a number of layers of electrical conductors are separated by ceramic insulating material. Such an arrangement provides a circuit pattern which can be used to interconnect electrical components and/or equipment of various kinds. In the case of interconnected electrical components, the components are often mounted at the surface of the arrangement.

The present invention seeks to provide an improved circuit arrangement.

According to a first aspect of this invention a circuit arrangement includes a planar substrate consisting of a plurality of insulating ceramic layers bonded together, some of which carry intermediate electrically conductive layers, a plurality of said layers being in the form of patterns of conductive tracks; a recess formed in the substrate and being constituted by apertures extending wholly through a plurality of the ceramic layers, at least one of which carries an intermediate electrically conductive layer; and a semiconductor device mounted within said recess and having electrical connections to at least one of said intermediate electrically conductive layers.

According to a second aspect of this invention a method of making a circuit arrangement includes the steps of forming electrically conductive patterns on a plurality of flexible insulating ceramic substrates, at least some of which have apertures formed through their thickness; assembling the substrates into a composite structure such that the apertures cooperate together to form an open recess in the structure; firing the ceramic substrates to form a rigid composite structure having internal electrically conductive patterns; mounting a semiconductor devices within the recess; and electrically connecting the device to an internal electrically conductive pattern.

The apertures in the flexible substrates can be formed before or after the formation of the electrically conductive patterns. In order to increase the effective thickness of a part of the composite structure, some of the apertured structures can be produced without conductive layers. Alternatively, substrates of different thicknesses could be used, but it is more convenient to fabricate the circuit arrangement from flexible ceramic substrates all having the same thickness.

Preferably the electrically conductive patterns are formed of conductive inks printed through an appropriately patterned screen mesh. The use of screen printing techniques on a flexible ceramic substrate permits fine patterns and closely controlled geometry to be readily achieved. By means of a number of aligned flexible layers which together form a composite substate, large and complex circuits can be fabricated, with suitable via connections linking the different layers of conductive patterns at the appropriate locations. As components can be mounted within the thickness of the composite structure, they are protected against damage.

By mounting the semiconductove device within a recess, it can be readily connected directly to intermediate layers of the composite structure, and by correctly choosing the depth of the recess, the overall thickness of the circuit arrangement is not increased by the presence of the semiconductor device.

An important aspect of the invention resides in the provision of a ceramic lid which encloses the recess so as to completely seal the semiconductor device within the thickness of the substrate. This avoids the need to provide additional packaging or protection for the semiconductor device, which conveniently takes the form of an unencapsulated chip or die.

Generally of course, such a chip or die will be given a protective film or coating of a passivated material during manufacture, with windows being left in the protective film to allow access to electrical contact pads. Typically, each semiconductor device comprises an integrated circuit having a large number of electronic elements, eg field effect transistors, which cooperate to constitute a gate array or the like. These devices are preferably connected to the composite structure by means of bonded gold wires.

Since it is not necessary to separately encapsulate each semiconductor device in a bulky plastics or ceramic package the overall thickness of the circuit arrangement can be kept to a very small dimension. Furthermore, the lid can be mounted flush with the upper surface of the composite substrate so as to result in a circuit arrangement having smooth surfaces. Of course, other kinds of components can also be mounted within the thickness of the composite structure if their heights are of suitable dimensions.

The invention is further described by way of example, with reference to the accompanying drawings, in which

Figure 1 illustrates a sectional view through a circuit arrangement in accordance with the invention, and

Figure 2 illustrates a plan view of the arrangement.

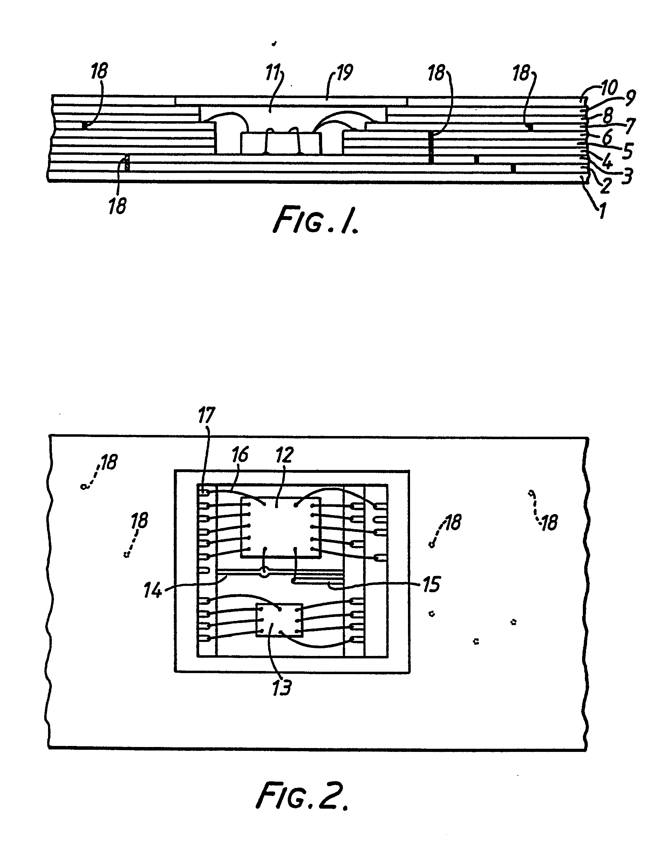

Referring to Figures 1 and 2, the circuit arrangement consists of the plurality of individual layers 1 to 10 each consisting of an insulating ceramic material, some layers of which carry an electrically conductive layer. Such a conductive layer may be a pattern of electrically conductive tracks or the layer may be a continuous sheet of conductive material and this latter may be positioned to provide electrical screening or high current paths as needed. Electrical via connections between electrically conductive layers can be positioned through intermediate layers of ceramic material which do not themselves carry electrical tracks. In the example shown in Figures 1 and 2 a recess 11 is formed in which two electronic devices 12 and 13 are mounted. These devices are located on the upper surface of layer 3 which also carries and supports conductive tracks 14 and 15 and these tracks are partially visible in Figure 2. The electronic devices are unpackaged semiconductor chips or dice, and electric connection is made to their peripheral pads by means of thin gold wires 16 which are bonded to electrically conductive pads 17 formed on those layers which project into the recess 11 or constitute the floor of the recess.

Electrical connections by means of the gold wires can be made from the semiconductor devices to different layers of the insulating substrate, for example in Figure 1 different wires 16 are linked to the layers 6 and 7.

The intermediate layers of the sandwich which makes up the composite structure can be electrically linked by means of vias such as 18 which extend from one layer to another. This aspect permits very complex circuits and interconnection patterns to be made within a very compact space.

The recess 11 is provided with a lid 19, which is also formed of one or more thickness of ceramic substrate and this lid 19 is sealed to the upper two layers 9 and 10 so as that the recess 11 is hermetically sealed. Although in this example, the lid is flush with the top surface of the layer 10, this is not necessary, and it can be mounted so as to form an additional layer. This avoids the need to provide expensive or bulky packaging to the electronic devices 12 and 13 to protect them. As the electronic devices 12 and 13 are unencapsulated and packaged, their size is extremely small and they can readily fit within a recess 11 such as is formed within the thickness of the circuit arrangement. Typically, each of the ten layers 1 to 10 shown in Figure 1 is extremely thin, of the order of 4,000ths of an inch thick, so that very complex circuits can be fabricated by means of such an arrangement.

Each of the layers 1 to 10 is initially in the form of an unfired flexible ceramic tape upon which a circuit pattern is formed by screen printing electrically conductive inks. After firing at a suitably high temperature the composite layers form a rigid body which has considerable strength and which is inert.

The way in which the circuit shown in Figures 1 and 2 is fabricated is as follows. Lengths of a thin flexible ceramic tape are taken and cut approximately to a portion of the correct size. Each of the portions, and in this example, there will be ten such portions, are provided with registration holes so that the different layers can be accurately aligned with each other. Using these alignment or registration holes, via holes are cut into those layers which require them, and at the same time apertures are cut so that when assembled they will constitute the recess 11. The via holes are subsequently filled with a suitable conductive ink having properties which are compatible with those of the ceramic tape material. In particular, this via ink has to be fairly viscous and to include a good proportion of solids so that it is retained within the via holes during handling and firing. The ink must also have properties such that it contracts with the ceramic tape as it is fired. Such materials are now well known and are readily available.

Following the formation of the vias and the apertures, electrically conductive tracks are formed as screen printed conductive patterns on the upper surfaces of those layers which require them using suitable conductive inks. In this example, only three or four such layers carry the electrical circuit patterns, but because such patterns can be fabricated to a very fine geometry and can be interconnected using vias between adjacent layers, it is possible to form very complex circuits in a relatively small space. Following the printing of all of the layers, of conductive inks, the layers of ceramic substrates are assembled together and heated under pressure so as to form a unitary composite structrue. During this stage, alignment of the different layers is maintained utilising the registration holes. Once the composite structure has been formed, the peripheral edges of it are trimmed so as to remove and discard the registration holes.

Subsequently, the composite structure is heated to a high temperature of about 800°C so as to completely fire the ceramic material and to burn off any remaining organic materials present. During this stage, the layers of ceramic material, which typically is largely alumina, form a single unitary rigid plate which is chemically inert.

Subsequently, the electronic components are mounted within the recess so formed and are electricaly linked to the various circuit patterns by means of fine gold wires which are bonded, by eg a thermo-compression bonding technique, both to the contact pads of the electronic devices and to the circuit pads carried by the composite structure.

As many separate recesses 11 can be formed as are required, and it may be more convenient for each recess to carry only a single component. This will enable the size of each recess to be small and enhance the strength and rigidity of the final circuit arrangement.

As each ceramic substrate is extremely thin it may be desirable to fabricate the lid 19 from two or three separate layers which are bonded together. The lid may be attached to the circuit arrangement, either by means of an epoxy resin, or by means of a brazing or soldering process if the lower surface of the lid and the upper surface of the layer 9 carries an appropriate metallisation. In each case, the bonding of the lid is such as to form a hermetic seal which protects the semiconductor components or other electronic components which are mounted within the recess. Instead of, or in addition to the semiconductor components, other kinds of components such as capacitors and resistors can advantageously be mounted in similar recesses within the thickness of a multi-layer composite circuit structure.

## Claims

1. A circuit arrangement including a planar substrate consisting of a plurality of insulating ceramic layers bonded together, some of which carry intermediate electrically conductive layers, a plurality of said layers being in the form of patterns of conductive tracks, a recess formed in the substrate and being constituted by apertures extending wholly through a plurality of ceramic layers, at least one of which carries an intermediate electrically conductive layer; and a semiconductor device mounted within said recess, and having electrical connections to at least one of said intermediate electrically conductive layers.

2. An arrangement as claimed in Claim 1 and wherein the recess is provided with a lid to enclose the recess.

3. An arrangement as claimed in Claim 2 and wherein the lid is ceramic and is sealed to the substrate so as to provide a hermetically sealed enclosure for the semiconductor device.

4. An arrangement as claimed in any of the preceding claims and wherein the recess contains a plurality of circuit components.

5. An arrangement as claimed in any of the preceding claims and wherein a plurality of said recesses are present, each containing a circuit component.

6. An arrangement as claimed in any of the preceding claims and wherein an interconnection is provided through the thickness of at least one of said insulating ceramic layers so as to electrically connect at least two of said electrically conductive layers.

7. A method of making a circuit arrangement including the steps of forming electrically conductive patterns on a plurality of flexible insulating ceramic substrates, at least some of which have apertures formed through their thickness; assembling the substrates into a composite structure such that the apertures cooperate together to form an open recess in the structure; firing the ceramic substrates to form a rigid composite structure having internal electrically conductive patterns; mounting a semiconductor device within the recess; and electrically connecting the device to an internal electrically conductive pattern.

8. A method as claimed in Claim 7 and wherein the electrically conductive patterns are formed of conductive ink printed through appropriately patterned screen meshes.

9. A method as claimed in Claim 7 or 8, and wherein holes are made in those insulating layers through which via connections are to be formed, and the holes filled with conductive ink prior to the firing of the ceramic.

10. A method as claimed in any of the Claims 7 to 9 wherein following the mounting of said semiconductor device within the recess, the recess is hermetically sealed by means of a lid to form an enclosure.

11. A method as claimed in Claim 10 and wherein the lid is formed of one or more fired ceramic layers.

FIG. 1.

FIG. 2.